# EUROPÄISCHE PATENTSCHRIFT

(11) **EP 0 843 358 B1**
(45) Veröffentlichungstag und Bekanntmachung des Hinweises auf die Patenterteilung: **10.05.2000**
(21) Anmeldenummer: 98101884.9
(22) Anmeldetag: 18.11.1993
(51) Int. Cl.: H01L 23/495, H01L 23/498

(54) **Elektronikmodul in Flachbauweise und Chipkarte**
Electronic flat-pack module and chipcard
Module électronique à type mince et carte à puce

(30) Priorität: 27.11.1992 CH 363392
(43) Veröffentlichungstag der Anmeldung: 20.05.1998
(62) Teilanmeldung aus: 93118564.9
(73) Patentinhaber: Sempac SA, 6330 Cham (CH)
(72) Erfinder: Nicklaus, Karl, 6330 Cham (CH)

(56) Entgegenhaltungen:
- EP-A- 0 339 763
- EP-A- 0 504 669
- DE-A- 3 130 213
- FR-A- 2 673 042
- US-A- 4 725 692
- US-A- 5 150 193
- PATENT ABSTRACTS OF JAPAN vol. 009, no. 110 (E-314), 15.Mai 1985 & JP 60 000747 A (HITACHI SEISAKUSHO KK), 5.Januar 1985,
- PATENT ABSTRACTS OF JAPAN vol. 010, no. 141 (E-406), 24.Mai 1986 & JP 61 005530 A (HITACHI SEISAKUSHO KK), 11.Januar 1986,

## Beschreibung

Die Erfindung betrifft ein Elektronikmodul in Flachbauweise, ein Verfahren zur Herstellung des Elektronikmoduls, eine Verwendung des Elektronikmoduls und eine Chipkarte mit dem Elektronikmodul.

Elektronikmodule dieser Art enthalten einen Halbleiterchip, auf welchem Informationen gespeichert bzw. speicherbar sind. Geeignete Bereiche des Halbleiterchips sind mit Aussenkontakten des Elektronikmoduls verbunden, welche an einer Flachseite, ggfs. durch eine Schutzfolie abgedeckt, oder längs der Ränder des Elektronikmoduls und damit an einer Fläche der Halbleiterchipkarte, ggfs. durch Schutzfolien abgedeckt, angeordnet sind. Beim Gebrauch von Halbleiterchipkarten, beispielsweise beim Einführen der Halbleiterchipkarten in einen Schlitz eines entsprechenden Gerätes, gelangen die Aussenkontakte mit zugehörigen Gegenkontakten des Gerätes in Berührung, was es dem Gerät ermöglicht, die im Halbleiterchip gespeicherten Daten zu lesen. In einfachen Ausführungsformen des Gerätes dient die Halbleiterchipkarte lediglich dazu, bei ihrer Einführung in das Gerät eine sofortige Reaktion zu bewirken; beispielsweise öffnet eine als sogenannter elektronischer Schlüssel bezeichnete Halbleiterchipkarte ein Schloss einer Türe oder eines Schrankes, wobei das als Lesevorrichtung ausgebildete Gerät des Schlosses lediglich die im Halbleiterchip gespeicherten Daten liest. In anderen Ausführungen ist das Gerät so ausgebildet, dass neue Daten im Halbleiterchip gespeichert und/oder bereits gespeicherte Daten ersetzt werden können; solche Geräte umfasst im allgemeinen neben der Leseeinrichtung eine Eingabeeinrichtung in Form einer Tastatur und einen Monitor. Im Zusammenhang mit solchen Komplizierteren Geräten verwendete Halbleiterchipkarten sind beispielsweise sogenannte Bankomat- oder Postomatkarten, mit deren Hilfe, meist unter zusätzlicher daktiler Eingabe eines PIN-Codes, Geld, Dienstleistungen wie Telefonverbindungen oder Waren bezogen werden können.

Aus praktischen Gründen weisen Halbleiterchipkarten dieser Art eine verhältnismässig geringe Dicke auf. Dadurch wird grundsätzlich die Dicke des Elektronikmoduls begrenzt.

Wegen der in der Praxis meist vorhandenen Notwendigkeit des Zusammenwirkens jeder Halbleiterchipkarte mit einer Vielzahl von Geräten bzw. der Akzeptanz einer Vielzahl von Halbleiterchipkarten durch jedes einzelne Gerät ist es ferner notwendig, dass die Abmessungen aller Halbleiterchipkarten innerhalb enger Toleranzen gleich sind; dies gilt sowohl für die Aussenabmessungen der Halbleiterchipkarten an und für sich wie auch für die Anordnung der Aussenkontakte innerhalb der Halbleiterchipkarte. Dadurch wird bei der Herstellung der vorbekannten Elektronikmodule bedingt, dass einerseits die Aussenkontakte innerhalb des Elektronikmodule und anderseits die Elektronikmodule innerhalb der Halbleiterchipkarten jeweils eine präzise vorbestimmte Lage einnehmen, so dass also die Herstellung der Kunststoffgehäuse und ihre Positionierung bei der Herstellung der Chipkarten mit höchster Präzision erfolgen muss, was materialbedingt nicht einfach zu realisieren ist.

Ein weiteres Erfordernis besteht darin, die Elektronikmodule so auszubilden, dass die Halbleiterchips sowohl bei der Herstellung der Elektronikmodule wie auch bei der Herstellung der Halbleiterchipkarten und bei der späteren Aufbewahrung und Handhabung der Halbleiterchipkarten vor Beschädigungen geschützt sind. Die Halbleiterchips, welche infolge ihrer kristallinen Struktur die Neigung haben, längs Bruchlinien parallel zu ihren Kanten zu brechen, sind häufig insbesondere bei der Aufbewahrung und Handhabung der Halbleiterchipkarte verhältnismässig grossen Druck- und Biegebeanspruchungen sowie hohen Temperaturschwankungen und entsprechenden Wärmedilatationen und internen Wärmedilatationsdifferenzen innerhalb von Elektronikmodul und Halbleiterchipkarte ausgesetzt. Durch eine geeignete Ausbildung des Halbleiterchipträgers und geeignete Art der Halbleiterchipmontage sucht man zu verhindern, dass die erwähnten Beanspruchungen einen Bruch des Halbleiterchips und/oder eine Trennung der verschiedenen Bestandteile des Elektronikmoduls zur Folge haben.

Ein weiteres Problem bilden die Abmessungen, einerseits, weil sie absolut gesehen klein sind, was die üblichen Probleme bei der Herstellung zur Folge hat, und anderseits, weil zwei gegensätzliche Forderungen zu befriedigen sind. Einerseits sollte das Elektronikmodul möglichst klein und insbesondere möglichst flach sein, anderseits wäre es erwünscht, einen möglichst leistungsfähigen, also eher grossflächigeren Halbleiterchip zu verwenden.

Schliesslich muss bei der Konzeption der Elektronikmodule darauf geachtet werden, dass sie bei ihrer Herstellung sowie bei der darauffolgenden Herstellung der Halbleiterchipkarten mittels Montageautomaten in vorteilhafter Weise handhabbar sind.

Aus der Literatur sind zahlreiche verschiedene Typen von Elektronikmodulen bekannt, und auch innerhalb der Typen unterscheiden sich die Elektronikmodule beträchtlich.

Die Elektronikmodule eines ersten, weit verbreiteten und vorteilhaften Typs weisen einen metallischen Systemträger auf. Ein solches Elektronikmodul wird beispielsweise durch die **EP-0 391 790** (SGS Thomson) beschrieben. Dieses Elektronikmodul besitzt einen metallischen Systemträger, der schlitzartige Durchbrüche aufweist, durch welche eine Chipinsel und Aussenkontakte begrenzt werden, welch letztere in einer Aussenfläche des Elektronikmoduls angeordnet sind. Auf dem metallischen Systemträger ist ein perforiertes Kunststoffband angeordnet, wobei dessen Perforationen so verteilt sind, dass die Durchbrüche des Systemträgers, jedoch nicht die Aussenkontakte und die Chipinsel durch das Bandmaterial abgedeckt sind. Ein Halbleiterchip ist auf der Chipinsel montiert und geeignete Bereiche des Halbleiterchips sind durch dünne elektrisch leitende Drähte mit den Aussenkontakten verbunden. In einer ersten Ausführungsform ist ein die Umgebung der Chipinsel umkreisender Ring auf dem Kunststoffband angeordnet. In einer zweiten Ausführungsform ist der Ring integral mit dem Kunststoffband hergestellt. Derjenige Bereich, der im Inneren des Ringes liegt, wird nun bis zur Höhe des Ringes mit Kunststoff ausgegossen und bildet das Elektronikmodul. Der Ring dient einerseits zur Begrenzung des Elektronikmoduls bzw. einer vergossenen Kunststoffmasse, welche das Gehäuse des Elektronikmoduls bildet und stellt anderseits einen Schutz für den Halbleiterchip dar. Die Herstellung beider Ausführungsformen dieses Elektronikmoduls ist verhältnismässig aufwendig; bei der ersten Ausführungsform bildet der Ring ein zusätzliches konstruktives Element, das gehandhabt werden muss, während bei der zweiten Ausführungsform der Ring zwar im Kunststoffband integriert ist, was aber zur Folge hat, dass die Formgebung des letzteren kompliziert ist.

Ein anderes Elektronikmodul mit an einer Aussenfläche liegenden Aussenkontakten, das ebenfalls auf einen metallischen Systemträger aufgebaut ist, wird durch die **EP-0 211 716** (Eurotechnique) beschrieben. Auch in diesem Systemträger werden eine Chipinsel und Aussenkontakte von Durchbrüchen begrenzt, welche verhältnismässig kompliziert ausgebildet sind. Der Halbleiterchip ist auf der Chipinsel festgeklebt, und die Verbindung zwischen geeigneten Bereichen des Halbleiterchips und den Aussenkontakten erfolgt in gleicher Weise wie oben beschrieben. Auch hier ist der Halbleiterchip von einer Kunststoffmasse umgossen. Einzelne flügelartige Bereiche des Sytemträgers sind um 90° nach oben ausgebogen und dienen zur besseren Verbindung der Kunststoffmasse mit dem Systemträger sowie zum Schutz des Halbleiterchips. Nachteilig an diesem Systemträger ist die verhältnismässig komplizierte Form des Systemträgers sowie die Notwendigkeit des Ausbiegens der Flügel, die sich mitten im Systemträger befinden, und zwar vor der Stabilisierung des Systemträgers durch eine Kunststoffmasse, mit welcher der Halbleiterchip umgossen wird, was die Gefahr einer Deformation des gesamten Systemträgers in sich birgt.

Die **US-5,134,773** (LeMaire) und die **GB-2 149 209** (GAO) offenbaren ebenfalls Elektronikmodule des oben erwähnten Typs mit metallischem Systemträger und an einer Fläche liegenden Aussenkontakten, bei welchen jedoch keine Massnahmen getroffen sind, um den Halbleiterchip vor Bruch schützen.

In der **JP-2102098** (Matsushita), der **JP-59227143** (Dainipon) und der **EP-0 505 290** (Fujitsu) sind weitere Elektronikmodule des bereits mehrfach erwähnten Typs mit metallischem Systemträger und an einer Aussenfläche liegenden Aussenkontakten beschrieben. Die Formgebung der Systemträger dieser Elektronikmodule ist sehr kompliziert, insbesondere weisen die Schlitze bzw. Ausstanzungen, welche die verschiedenen Bereiche der Systemträger trennen, nicht gerade sondern gerundete bzw. schwalbenschwanz- oder zickzackartigartige bzw. verwinkelte Berandungen auf; mit diesen Formgebungen sollen verschiedene Zwecke erreicht werden, aber bei den insgesamt geringen Abmessungen muss es als Nachteil betrachtet werden, dass ausserordentlich kompliziert berandete Schlitze herzustellen sind.

Ein weiteres Elektronikmodul des bisher beschriebenen Typs mit metallischem Systemträger und an einer Aussenfläche liegenden Aussenkontakten wird durch die **EP-0 591 668** offenbart. Der sehr kleine Halbleiterchip wird auf einer achteckigen Chipinsel festgeklebt. Der Systemträger ist mit einer Folie bedeckt, mit Ausnahme eines ebenfalls achteckigen Bereiches, in welchem sich die Chipinsel mit dem Halbleiterchip sowie die Aussenkontakte befinden. Die Möglichkeit, durch die Folie eine Schutzwirkung für den Halbleiterchip zu erhalten, wird nicht ausgenützt, da sich der Halbleiterchip in der Aussparung der Folie befindet, wodurch ausserdem die Abmessung des Halbleiterchips begrenzt wird.

Auch das in der **EP-0 197 438** beschriebene Elektronikmodul besitzt einen metallischen Systemträger und in einer Aussenfläche angeordnete Aussenkontakte. Bei diesem Elektronikmodul sind zur leitenden Verbindung von Halbleiterchip und Aussenkontakten keine Drähte vorgesehen, vermutlich weil man Probleme mit den extrem dünnen und verletzlichen Drahtverbindungen zu vermeiden suchte. Das Elektronikmodul enthält eine sogenannte Pastille, welche eigentlich ein Baustein des Elektronikmodules ist und den Halbleiterchip sowie die Verbindungen des Halbleiterchips zu Kontaktbereichen umfasst. Die Pastille wird so auf den Systemträger gebracht, dass ihre Kontaktbereiche mit den Aussenkontakten des Systemträgers in Berührung gelangen. Nachteilig an diesem Elektronikmodul ist jedoch, dass keine Massnahmen zum Schutz des Halbleiterchips getroffen sind.

Bei einem zweiten Typ von Elektronikmodulen, die ebenfalls metallische Systemträger besitzen, sind die Halbleiterchips auch ohne besondere Massnahmen verhältnismässig gut geschützt, da sie allseitig, das heisst an ihren beiden Flachseiten, von Kunststoff umgeben sind. Dies hat allerdings zur Folge, dass die Aussenkontakte nicht an einer Aussenfläche des Elektronikmoduls angeordnet sein können sondern seitlich aus dem das Gehäuse bildenden Kunststoff hinausragen. Wenn auch diese Elektronikmodule anders aufgebaut sind als die Elektronikmodule des bisher beschriebenen Typs, so enthalten sie doch mindestens teilweise vergleichbare konstruktive Elemente und bezüglich ihrer Konstruktion und Herstellung müssen ähnliche Probleme gelöst werden.

Elektronikmodule dieses zweiten Typs sind in der **EP-0 321 326** (Thomson) sowie in der **US-5,126,823** (Otsuka) beschrieben. Beim letzteren handelt es sich um ein Multichip-Elektronikmodul mit einem metallischen Systemträger mit zwei Chipinseln und einer Vielzahl von randständigen, aus der Ebene des Systemträgers abgebogenen Aussenkontakten, sowie mit zwei Halbleiterchips, die in üblicher Weise mit den Aussenkontakten verbunden sind. Die Chipinseln und die Halbleiterchips sind rechteckig, annähernd gleich gross und relativ zu den Kanten des Elektronikmoduls um etwa 45° gedreht, wodurch ein etwa gleichartiger Verlauf aller Aussenkontakte erreicht werden soll. Ähnliche Elektronikmodule wie das soeben beschriebene, bei welchem der Systemträger im Bereich des Halbleiterchips beidseitig mit Kunststoff umgossen und die Aussenkontakte durch eine Vielzahl randsträndiger abgewinkelter Bereiche des Systemträgers gebildet sind, jedoch mit nur einem Halbleiterchip, sind auch aus der **JP-60171733** (Suzuki), der **JP-2-54957** (Yasuhara) und der **US-4,937,565** (Kohara) bekannt.

Sodann beschreibt die **GB-1 383 297** (Beavitt) ein Elektronikmodul des zweiten Typs mit zur Seite ragenden Aussenkontakten, bei welchem die leitende Verbindung zwischen Halbleiterchip und Systemträger wie bei der oben beschriebenen Pastillen-Bauweise ohne die sonst üblichen Drahtverbindungen zustande kommt, indem die einen Enden streifenförmiger Teile des Systemträgers mit geeigneten Bereichen des Halbleiterchips direkt in Berührung stehen, während die anderen Enden dieser Teile die Aussenkontakte bilden. Ein ebenfalls nach demselben Prinzip konzipiertes Elektronikmodul ist sodann bekannt aus **JP-GM-Hei-1-44658** (Rythm Watch); bei diesem Elektronikmodul bilden anstelle von Leitungsdrähten Teile des Systemträgers die leitende Verbindung zum Halbleiterchip.

Ein weiteres Elektronikmodul des zweiten Typs mit einem metallischen Systemträger und mit einer Vielzahl sich längs zweier paralleler Seiten erstreckender Aussenkontakte ist aus der **JP-403073560** (Hosoya) bekannt.

Ausser den bisher beschriebenen Elektronikmodulen, die alle einen metallischen bzw. leitenden Systemträger besitzen, sind zahlreiche weitere Elektronikmodule bekannt, die keinen metallischen Systemträger aufweisen und die daher grundsätzlich nicht mit dem Gegenstand der Erfindung vergleichbar sind. Elektronikmodule ohne metallische Systemträger sind beispielsweise in der **DE-38 09 005** (Hitachi) und der **WO-9101533** (Schneider) beschrieben.

Zusammenfassend kann festgestellt werden, dass zwar eine Vielzahl von Elektronikmodulen in Flachbauweise bekannt ist, dass aber keines von ihnen die weiter oben beschriebenen Anforderungen, die an solche Elektronikmodule gestellt werden, vollständig zu befriedigen vermag.

Die Aufgabe der Erfindung wird somit darin gesehen,
- ein Elektronikmodul zu schaffen, welches sowohl bezüglich seiner Herstellung wie bezüglich seines Gebrauches optimal ausgebildet ist,
- ein Verfahren zur Herstellung des erfindungsgemässen Elektronikmoduls aufzuzeigen,
- eine Verwendung des erfindungsgemässen Elektronikmoduls zu zeigen und
- eine Chipkarte mit dem erfindungsgemässen Elektronikmodul vorzuschlagen.

Diese Aufgabe wird erfindungsgemäss durch die Merkmale der unabhängigen Patentansprüche **1**, **7** und **9** gelöst. Vorteilhafte Weiterbildungen der Erfindung werden durch die Merkmale der jeweiligen abhängigen Patentansprüche definiert.

Wie die folgenden Darlegungen verdeutlichen, wurde bei der Konzeption des erfindungsgemässen Elektronikmoduls darauf geachtet, alle konstruktiven Einzelheiten so zu gestalten, dass sie sich im Hinblick auf Herstellung und/oder Gebrauch sowohl des Elektronikmoduls selbst als auch einer Halbleiterchipkarte als vorteilhaft erweisen.

Das neue Elektronikmodul ist auf einem metallischen Systemträger aufgebaut und weist ein Kunststoffgehäuse aus einem vergiessbaren Kunststoff auf. Dieser Systemträger ist aus einem Abschnitt eines Metallstreifens gebildet und weist mehrere, im allgemeinen durch eine Vorstanzung erzeugte, Durchbrüche auf. Der Systemträger ist eben, mit Ausnahme von Randbereichen, die in einem späteren Schritt der Herstellung des Elektronikmoduls, aus seiner Ebene ausgebogen werden, jedoch erst nach der Herstellung des Kunststoffgehäuses, so dass keine Gefahr besteht, den Systemträger während des Biegevorganges zu beschädigen. Ein Teil der Durchbrüche besteht aus schmalen Schlitzen, wobei jeder Schlitz in seiner Längsrichtung durch zwei Geraden berandet ist; diese können parallel oder nicht parallel sein. Die schlitzartigen Durchbrüche begrenzen eine Chipinsel und Aussenkontakte, welche alle im wesentlichen rechteckig, ggfs. quadratisch, sind. Die Chipinsel ist der Ort, über welchem ein Halbleiterchip montiert ist; der Halbleiterchip ist grössenmässig nicht auf die Abmessungen der Chipinsel begrenzt,sondern kann über diese hinausragen. Für die Abmessungen des Halbleiterchips sind zwei Tendenzen massgebend. Einerseits besteht das Bedürfnis, die Informationskapazität des Halbleiterchips zu erhöhen, was grundsätzlich zu einer Vergrösserung derselben führt. Anderseits läuft die Entwicklung der Halbleiterchips in Richtung auf immer kleinere Abmessungen zu. Geeignete Bereiche des Halbleiterchips sind über Drahtverbindungen mit je einem zugehörigen Aussenkontakt verbunden. Zwischen dem Halbleiterchip und dem Systemträger befindet sich eine Schicht, welche den Chip isoliert; hierbei kann es sich um eine Klebstoffschicht handeln, mittels welcher der Halbleiterchip montiert wird, oder um eine flexible flächige Schicht in Form einer Folie, auf welcher der Halbleiterchip mit Klebstoff montiert wird, und die so bemessen ist, dass sie mindestens die Fläche des Halbleiterchips abdeckt, die aber vorzugsweise grösser ist und sich insbesondere auch über Teile der Aussenkontakte erstrecken kann, wobei sogar die Befestigungsstellen der Drahtverbindungen auf den Aussenkontakten im Bereichs der Folie liegen können, die in solchen Fällen an geeigneten Stellen perforiert ist; der Chip kann, zur Verkleinerung der Bauhöhe, auch in einer Aussparung bzw. Perforation der Folie mit Klebstoff auf dem Systemträger befestigt werden. Die im allgemeinen geradlinig begrenzte bzw. rechteckige Folie hat verschiedene Aufgaben. Erstens ermöglicht die Folie die Montage eines verhältnismässig grossflächigen und damit leistungsfähigen Halbleiterchips auf einer kleinen Chipinsel bzw. in einem relativ kleinen Elektronikmodul und dient dazu, einen Halbleiterchip, dessen Randbereiche sich bis über die Aussenkontakte erstrecken, gegen die Aussenkontakte zu isolieren. Zweitens wirkt die Folie als mechanisches Dämpfungs- und Ausgleichsglied zum Schutz des Halbleiterchips vor Schlägen und gleicht unterschiedliche Wärmedilatationen im Elektronikmodul zwischen dem Halbleiterchip und dem Systemträger aus. Drittens verhindert die Folie beim Vergiessen der Gussmasse des Kunststoffgehäuses, dass der noch flüssige Kunststoff durch die schlitzförmigen Durchbrechungen in der Umgebung der Aussenkontakte dringt und sich gehäuseaussenseitig an den Aussenkontakten, welche freiliegen müssen, anlagert; dies ist deshalb von Bedeutung, weil eine niedrigviskose Giessmasse verwendet werden muss, da hochviskose Giessmassen während ihres Einströmens die sehr zarten und anfälligen Drahtverbindungen beschädigen würden. Der Halbleiterchip ist übereck auf der Chipinsel angeordnet, das heisst, dass jede seiner Kanten unter einem vorbestimmten Winkel, der jedenfalls grösser ist als der Herstellungs-Toleranzbereich für diesen Winkel, vorzugsweise unter etwa 45°, zu den die Chipinsel begrenzenden schlitzförmigen Durchbrüchen verläuft. Auf diese Weise fallen die durch diese schlitzförmigen Durchbrüche verursachten Schwächungslinien des Systemträgers nicht mit den parallel zu den Kanten bzw. Rändern des Halbleiterchips gerichteten potentiellen Bruchlinien des Halbleiterchips zusammen, wodurch die Bruchgefahr des Halbleiterchips reduziert wird. Dies ist um so wichtiger, je grösser der verwendete Halbleiterchip ist, da grosse Halbleiterchips in Chipkarten vermehrt Biegebeanspruchungen unterliegen und dadurch bruchgefährdeter sind als kleine. Das Elektronikmodul umfasst schliesslich das schon erwähnte Gehäuse aus der Kunststoffmasse, mit welcher im wesentlichen der ebene Bereich des Systemträgers einschliesslich natürlich der Folie bedeckt und der Halbleiterchip sowie die Drahtverbindungen umgossen bzw. umpresst sind. Aus dem Kunststoffgehäuse ragen lediglich die weiter oben erwähnten Randbereiche des Systemträgers. Diese Randbereiche werden erst nach der Härtung des Kunststoffes ausgebogen bzw. abgekröpft, also erst wenn der Systemträger durch den Kunststoff fixiert ist, da dann, wie weiter oben erwähnt, bei diesem Biegevorgang keine Deformation des Systemträgers zu befürchten ist.

Wie schon erwähnt, ist die Grösse der Chipinsel nicht massgebend für die Grösse des auf ihr montierbaren Halbleiterchips. Dieser kann sich mit der Chipinsel decken oder kleiner oder grösser als die Chipinsel sein; im letzteren Fall kann er sich mit den Aussenkontakten überlappen.

Auch die Folie kann verschieden bemessen sein. Kleine Folien erstrecken sich maximal bis zu den die Chipinsel begrenzenden Durchbrüchen, grosse Folien erstrecken sich über die Chipinsel hinaus, jedoch nicht bis zu den Randbereichen des Systemträgers.

Das neue Elektronikmodul wird erfindungsgemäss in einer Chipkarte verwendet. Die Chipkarte weist im wesentlichen dieselbe Höhe auf wie das gesamte Elektronikmodul, höchstens vermehrt um die Dicke von an den Flachseiten der Chipkarte angeordneten Folien. Die zur Verfügung stehende Höhe wird also vom Elektronikmodul voll ausgenutzt, so dass dieses so hoch wie möglich ausgebildet sein kann. Das Elektronikmodul ist somit nur seitlich von der Kunststoffmasse der Chipkarte umgeben. Die Positionierung des Elektronikmoduls beim Giessen der Chipkarte erfolgt nicht durch Positionierung des Kunststoffgehäuses des Elektronikmoduls sondern durch Positionierung des Systemträgers innerhalb der Chipkarte. Ungenauigkeiten bei der Herstellung des Kunststoffgehäuses des Elektronikmoduls sind also in gewissen Grenzen ohne Belang für die Positionierung der Aussenkontakte.

Wie schon erwähnt, kann bei der Verwendung des Elektronikmoduls zur Herstellung einer Chipkarte einseitig oder beidseitig eine Dekorations- oder Etikettierfolie verwendet werden.

Die neue Chipkarte kann die Form einer Kreditkarte oder eine beliebige andere Form aufweisen. Chipkarten, welche als elektronische Schlüssel verwendet werden, weisen vorzugsweise schlüsselähnliche Konturen auf.

Weitere Einzelheiten und Vorteile der Erfindungen werden im folgenden anhand von Beispielen und mit Bezug auf die Zeichnung ausführlich beschrieben. Es zeigt:
- **Fig. 1**: einen Systemträger für eine erste Ausführungsform eines Elektronikmoduls nach der Erfindung, von oben;
- **Fig. 2 - 3**: aufeinanderfolgende Stufen während der Herstellung des auf dem Systemträger gemäss **Fig. 1** aufgebauten Elektronikmoduls, von oben;
- **Fig. 4**: den in **Fig. 1** dargestellten Systemträger mit einem Halbleiterchip in einer Spritzgiessform, in welcher das in **Fig. 2** gezeigte Zwischenprodukt hergestellt wird, in einem Schnitt entlang der Linie **IV - IV** der **Fig. 2**;
- **Fig. 5**: das fertige, vom Systemträger freigeschnittene und verformte Elektronikmodul, in einem Schnitt entlang der Linie **V - V** der **Fig. 3**;
- **Fig. 6**: das in **Fig. 6** dargestellte Elektronikmodul, in einem Schaubild;
- **Fig. 7**: das in den **Fig. 6** und **7** dargestellte Elektronikmodul, eingelegt und positioniert in einer weiteren Spritzgiessform, in welcher das Elektronikmodul zur Herstellung einer Chipkarte umgossen wird, in vergrössertem Massstab, in einem Schnitt;
- **Fig. 8**: einen Systemträger für eine zweite Ausführungsform des Elektronikmoduls, in gleicher Darstellung wie **Fig. 1;**
- **Fig. 9 - 10**: aufeinanderfolgende Herstellungsstufen des auf dem Systemträger der **Fig. 8** aufgebauten Elektronikmoduls, in den Fig. 2 und 3 entsprechenden Darstellungen;
- **Fig. 11**: das in den **Fig. 9** und **10** dargestellte Elektronikmodul, von oben;
- **Fig. 12**: das in den **Fig. 9 - 11** dargestellte Elektronikmodul, ausschnittweise in vergrössertem Massstab, in einem Schnitt längs der Linie **C - C** der **Fig. 11**, und
- **Fig. 13**: das in **Fig. 11** dargestellte Elektronikmodul, ausschnittweise in vergrössertem Massstab, in einem Schnitt längs der Linie **D - D** der **Fig. 11**.

Es werden im folgenden die Einzelheiten eines Systemträgers sowie die Herstellung und der Aufbau eines Elektronikmoduls und dessen Eingiessen in einer Chipkarte für zwei Ausführungsformen des Elektronikmoduls beschrieben.

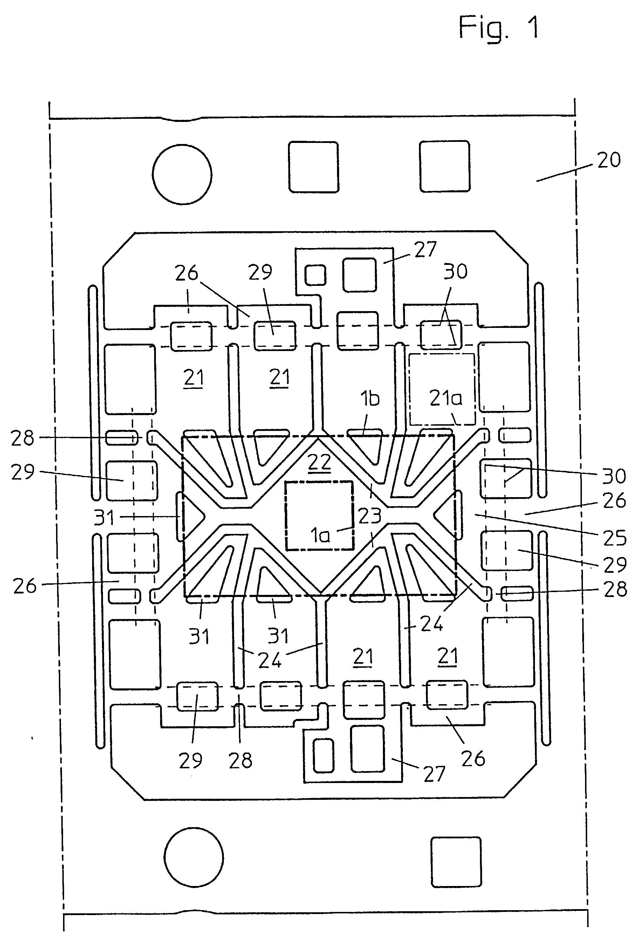

**Fig. 1** bezieht sich auf die erste Ausführungsform und zeigt stark vergrössert einen Abschnitt eines Systemträgers **20** in Form einer flachen, normalerweise gestanzten Blechstruktur, der üblicherweise auch als 'lead frame' bezeichnet wird. Wie mit strichpunktierten Linien angedeutet, schliessen seitlich weitere, gleichartige Abschnitte an, das heisst, es wird in bekannter Weise ein längerer, gestanzter Metallstreifen mit einer Mehrzahl von Abschnitten nach **Fig. 1** verwendet. Im Zentrum des Systemträgers **20** befindet sich eine viereckige, vorzugsweise rechteckige bzw. quadratische Chipinsel **22**. Diese ist durch schlitzartige Durchbrüche **23** begrenzt und beidseitig an Brücken **25** gehalten.

Die schlitzartigen Durchbrüche **23** kommunizieren mit anderen schlitzartigen Durchbrüchen **24**, und die letzteren begrenzen zusammen mit weiteren Durchbrüchen etwa rechteckige Bereiche des Systemträgers **20**, welche dazu bestimmt sind, am fertigen Elektronikmodul Aussenkontakte **21** zu bilden. Beim vorliegenden Beispiel handelt es sich um ein Elektronikmodul für eine Halbleiterchipkarte in der Art einer Kreditkarte, weshalb entsprechend der hierfür eingeführten Norm acht Aussenkontakte **21**, nämlich je vier in zwei parallelen Reihen und an vorbestimmten Stellen innerhalb der Chipkarte, vorgesehen sind. Zur Verdeutlichung ist in **Fig. 1** am einen Aussenkontakt das eigentliche Kontaktfeld **21a** strichpunktiert umrandet.

Beim vorliegenden Beispiel weisen die Aussenkontakte **21** wie auch die Brücken **25** in Bereichen, die in der Umgebung der Chipinsel **22** liegen, zusätzliche Durchbrüche **31** auf. Weiter ausserhalb sind in jedem Aussenkontakt **21** und in den beiden Brücken **25** fensterartige Durchbrüche **29** vorgesehen. Etwa in Linie mit diesen Durchbrüchen sind die Aussenkontakte **21** und die Brücken **25** untereinander durch Stege **28** verbunden, an denen die schlitzartigen Durchbrüche **24** enden.

An den Randbereichen des Systemträgers **20**, genauer an den Brücken **25** und an den Aussenkontakten **21**, sind sodann über die Stege **28** hinausreichende Fortsätze **26, 27** angeformt. In **Fig. 1** sind schliesslich paarweise parallele, unterbrochene Linien **30** eingezeichnet, die im Bereich der Stege **28** und der fensterartigen Durchbrüche **29** liegen und ein Rechteck umschreiben; bei diesen Linien **30** handelt es sich um Biegelinien, entlang welchen die Randbereiche des Systemträgers **20**, das heisst die Fortsätze **26** und **27** später aus der Ebene des Systemträgers **20** ausgebogen bzw. abgekröpft werden. Die Bedeutung der in diesem Beschreibungsabschnitt erwähnten Einzelheiten des Systemträgers **20** wird weiter unten im Zusammenhang mit der Herstellung des Elektronikmoduls und dessen Einbau in eine Chipkarte näher erläutert.

Oberhalb der Chipinsel **22** ist ein Halbleiterchip mit integrierter Schaltung angeordnet, von welchem geeignete Bereiche mittels elektrisch leitender Drahtverbindungen mit den Aussenkontakten **21** elektrisch verbunden werden. Die Dimensionen des Halbleiterchips sind nicht auf die Dimensionen der Chipinsel **22** begrenzt. In **Fig. 1** sind zwei Halbleiterchips **1a**, **1b** strichpunktiert eingezeichnet, von welchen in Wirklichkeit nur ein Halbleiterchip **1a** oder **1b** montiert wird. Der kleine, quadratische Halbleiterchip **1a** findet vollständig auf der Chipinsel **22** Platz. Der Halbleiterchip **1b**, der rechteckig ausgebildet und wesentlich grösser ist als der Halbleiterchip **1a**, ragt allseitig über die Chipinsel **22** hinaus und überlappt sich teilweise mit den benachbarten Aussenkontakten **21**; die Abmessungen des eingezeichneten Halbleiterchips **1b** entsprechen den beim vorliegenden Beispiel etwa maximal möglichen Abmessungen des Halbleiterchips.

Von wesentlicher Bedeutung ist, dass die schlitzartigen Durchbrüche **23**, von welchen jeder in seiner Längsrichtung beidseitig durch eine Gerade begrenzt ist, und welche ihrerseits die Chipinsel **22** beranden und sie von den Aussenkontakten **21** trennen, zu den Kanten des quadratischen oder rechteckigen Halbleiterchips **1a**, **1b** schiefwinklig verlaufen, unter einem vorbestimmbaren Winkel, vorzugsweise wie dargestellt unter einem Winkel von etwa 45°, so dass der Halbleiterchip **1** relativ zur Chipinsel **22** übereck angeordnet ist. Zusätzlich von Vorteil ist es, wenn wenigstens ein Teil der die Aussenkontakte **21** trennenden, mit den schlitzartigen Durchbrüchen **23** kommunizierenden schlitzartigen Durchbrüche **24** entlang geknickter Linien verlaufen, wodurch diese schlitzartigen Durchbrüche **24** wenigstens zum Teil, hauptsächlich innerhalb der Begrenzungen des Halbleiterchips **1b**, ebenfalls zu den Kanten des Halbleiterchips **1b** schiefwinklig stehen. In der Blechstruktur des Systemträgers **20** bilden einerseits die erwähnten schlitzartigen Durchbrüche **23, 24** unvermeidliche Schwächungslinien. Anderseits ist es so, dass in der Struktur des Einkristallmaterials, meist Silicium, aus dem die Halbleiterchips **1** hergestellt sind, Brüche, meist infolge von Biegebeanspruchungen, praktisch immer parallel zu den Kanten der Halbleiterchips **1** auftreten. Durch die vorgenannten Massnahmen bzw. die Übereckstellung des Halbleiterchips **1** relativ zur Chipinsel **22** wird erreicht, dass die Schwächungslinien des Systemträgers **20** nicht parallel zu den potentiellen Bruchlinien des Halbleiterchips **1** verlaufen, wodurch das Bruchrisiko für den Halbleiterchip **1** im mechanischen Verbund des Elektronikmoduls erheblich vermindert ist.

Beim vorliegenden Beispiel ist die Anordnung so getroffen, dass die Diagonalen der quadratischen Chipinsel **22** zu den beiden Reihen der Aussenkontakte **21** parallel bzw. senkrecht stehen; die Chipinsel **22** könnte, bei gleicher Richtung der Diagonalen, etwa auch rhombusförmig ausgebildet sein. Jedoch ist grundsätzlich, beispielsweise bei einer anderen Anordnung der Aussenkontakte, auch eine umgekehrte Anordnung denkbar, indem, bezogen, auf die Hauptachsen des Systemträgers **20**, eine quadratische oder rechteckige Chipinsel achsparallel zum Systemträger **20**, der Halbleiterchip dagegen schiefwinklig zum Systemträger **20** angeordnet würde. Auch der Verlauf der die Aussenkontakte trennenden schlitzartigen Durchbrüche **24** kann variiert werden, wobei der angestrebte Effekt in unterschiedlichem Ausmass durch die zum Halbleiterchip **1b** schiefstehenden Abschnitte dieser Durchbrüche **24**, vor allem in den vom Halbleiterchip **1b** überdeckten Bereichen, erzielt wird.

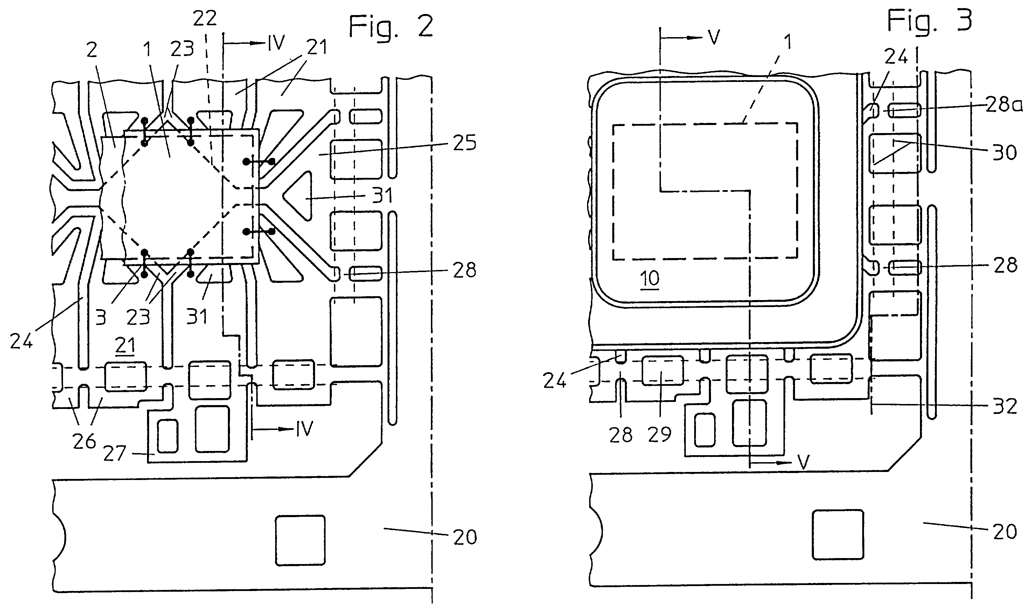

Anhand der **Fig. 2, 3** und **4** werden nun wesentliche Schritte der Herstellung des Elektronikmoduls, ausgehend vom Systemträger **20** nach **Fig. 1**, beschrieben. Gemäss **Fig. 2** ist der rechteckige Halbleiterchip **1** auf der Chipinsel **22** des Systemträgers **20** montiert. Dieser Halbleiterchip **1** ist etwas kleiner als der maximale noch montierbare Halbleiterchip **1b** gemäss **Fig. 1**, jedoch ragt der Halbleiterchip **1** erheblich über die Chipinsel **22** hinaus und überlappt sich mit benachbarten Bereichen der Aussenkontakte **21**. Es sind bereits Drahtverbindungen **3** von entsprechenden Bereichen der Schaltung des Halbleiterchips **1** zu den einzelnen Aussenkontakten **21** auf bekannte Weise hergestellt worden. Vor der Montage des Halbleiterchips **1** auf dem Systemträger **20** wird eine isolierende, mindestens auf ihrer dem Systemträger **20** zugewandten Fläche klebende Folie **2** auf dem Systemträger **20** angebracht. Diese hat hier etwa das Format des Halbleiterchips **1** und besteht aus einem temperaturbeständigen Kunststoff, zum Beispiel Polyamid oder Polyester mit einer Klebstoff-Beschichtung, welche bei erhöhter Temperatur polymerisiert. Eine solche Folie **2** hat den Vorteil, erhebliche materialbedingte Unterschiede in der Wärmedilatation zwischen dem metallischen Systemträger **20** und dem Halbleiterchip **1** auszugleichen und ausserdem Schläge, die von aussen auf den Systemträger **20** einwirken, gegenüber dem Halbleiterchip **1** zu dämpfen. Ferner wird durch die Folie **2** der Halbleiterchip **1** gegenüber den Aussenkontakten **21** elektrisch isoliert. Die Montage des Halbleiterchips **1** sowie das Herstellen der Drahtverbindungen **3** gemäss **Fig. 2** erfolgen vollautomatisch auf leistungsfähigen Montageeinrichtungen, wie sie für die Montage von Halbleiterchips auf Systemträgern bewährt und verbreitet sind.

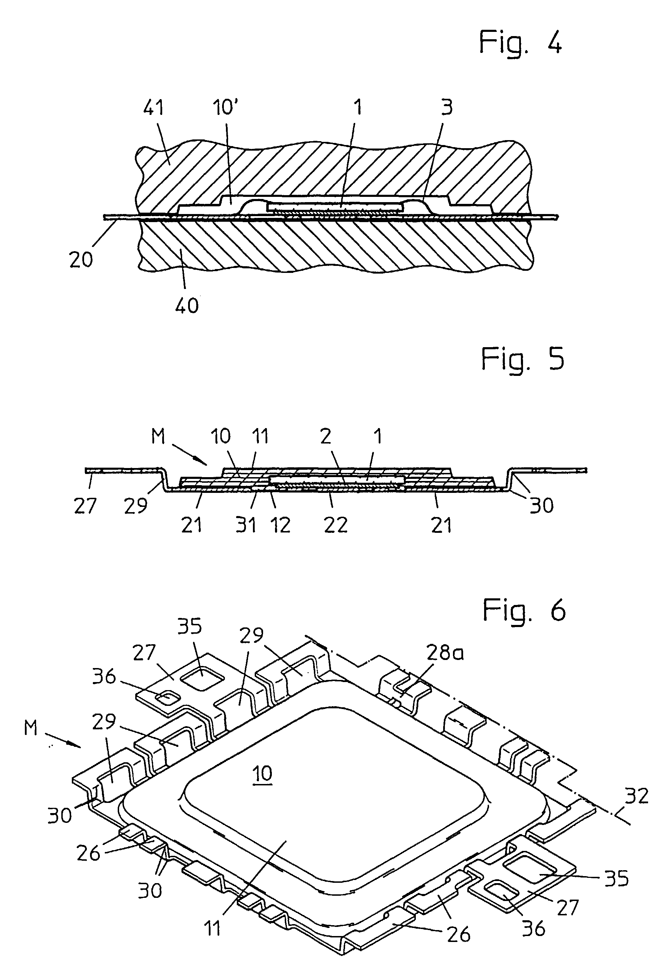

Anschliessend an die Montage nach **Fig. 2** wird der mit dem Halbleiterchip **1** bestückte Systemträger **20** zwecks Herstellung eines flachen Kunststoffgehäuses **10** in eine Spritzgiessform eingebracht, wie es schematisch in **Fig. 4** dargestellt ist; vorzugsweise handelt es sich um eine Mehrfachform, in welcher die Kunststoffgehäuse mehrerer Elektronikmodule gleichzeitig hergestellt werden können. Auf der im wesentlichen ebenen, in den **Fig. 4** bis **6** unten liegenden Formhälfte **40** liegt der ebenfalls ebene Systemträger **20** ganzflächig auf, während die obere Formhälfte **41** den Formhohlraum **10'** bildet. In diesem werden der Halbleiterchip **1** und der Systemträger **20**, mit Ausnahme von dessen Randbereichen, die aus dem Formhohlraum **10'** der Spritzgiessform hinausragen, durch Spritzgiessen mit Kunststoffmasse umgossen bzw. umpresst, wodurch die Aussenkontur des Kunststoffgehäuses **10** geformt wird.

Das ausgeformte Zwischenprodukt mit dem Kunststoffgehäuse **10** ist in **Fig. 3** dargestellt. Beim Spritzgiessen sind sämtliche schlitzartigen Durchbrüche **23** und **24** bis zu den Stegen **28** und ausserdem sämtliche weiteren Druchbrüche gemäss **Fig. 1** mit dem Kunststoff gefüllt worden, mit Ausnahme natürlich derjenigen Durchbrüche und Durchbruchsbereiche, die durch die Folie **2** abgedeckt sind. Die Kunststoffmasse schliesst, mit der Aussenseite des Systemträgers **20** auf der unteren Formhälfte **40** aufliegend, gemäss **Fig. 4** überall bündig ab; dies gilt insbesondere auch im Querschnitt sämtlicher Durchbrechungen **31**. Die eine, in den **Fig. 4** und **5** untenliegende, Aussenfläche des Kunststoffgehäuses **10** enthält also Flächenteile, die durch den Systemträger **20** gebildet sind, insbesondere auch die Aussenkontakte **22**, und Flächenteile, die durch die Kunststoffmasse gebildet sind, welche durch die nicht von der Folie **2** überdeckten Durchbrüche gedrungen ist.

Als Kunststoffmasse für das Kunststoffgehäuse **10** wird ein Duroplast oder Kunstharz mit geringer Viskosität verwendet, um die Drahtverbindungen während des Giessvorganges nicht durch den unter Druck einströmenden Kunststoff zu gefährden. Die Folie **2** verhindert wirksam, dass der Kunststoff trotz seiner geringen Viskosität an die Unterseite der Aussenkontakte **22** gelangt. Es wird ein Kunststoff mit möglichst geringem thermischen Ausdehnungskoeffizienten verwendet, wie er zum Umpressen von Silicium-Halbleiterchips unter der Bezeichnung 'low stress'-Masse mit hohem Quarzanteil bekannt ist. Das Metall des Systemträgers **20** hat demgegenüber einen hohen thermischen Ausdehnungskoeffizienten und dehnt sich in der Pressform **40, 41** bei der Verarbeitungstemperatur des einzupressenden Kunststoffes entsprechend aus. Beim anschliessenden Abkühlen des Metalls schrumpft dieses entsprechend und umschliesst bei den Durchbrüchen **31** den diese ausfüllenden, aushärtenden Kunststoff, wobei ein Pressitz hoher Festigkeit und Dichte entsteht. Dadurch wird eine mechanisch stabile gegenseitige Verankerung von Metallteilen und Kunststoff erreicht, ohne dass der letztere sich beim Giessvorgang ausserhalb der Metallteile ausbreiten müsste und ohne dass eine Verformung oder Dickenbearbeitung des Metalls erforderlich wäre.

Das verhältnismässig flache Kunststoffgehäuse **10** kann in der Dicke abgestuft sein, beispielsweise wie es aus den Fig. **4** bis **6** hervorgeht. Die volle Gehäusedicke ist dabei nur in einem zentralen Bereich vorhanden, wo der Kunststoff den Halbleiterchip **1** umschliesst und die den Aussenkontakten **22** bzw. der unteren Flachseite **12** gegenüberliegende obere Flachseite **11** des Kunststoffgehäuses **10** bildet.

Das nach dem Pressen des Kunststoffgehäuses **10** ausgeformte Zwischenprodukt nach **Fig. 3** wird nun weiterverarbeitet. Zunächst wird entlang von zwei symmetrischen Linien **32**, von welchen in **Fig. 3** nur die eine sichtbar ist, das Elektronikmodul aus dem Rahmen des Systemträgers **20** freigeschnitten. Gleichzeitig werden rings um das Kunststoffgehäuse **10** die Stege **28** ausgestanzt, mit Ausnahme eines Steges **28a** gemäss **Fig. 3** und **Fig. 6**, welcher die Chipinsel **22** über die eine Brücke **25** mit dem einen Aussenkontakt, der in **Fig. 1** sichtbar ist, elektrisch verbindet, welcher den Masseanschluss für die Schaltung des Elektronikmoduls bildet. In diesem Zustand können die elektrischen Funktionen des Elektronikmoduls über seine Aussenkontakte **22** getestet werden. Sodann werden im vorliegenden Fall, wo das Elektronikmodul zum Eingiessen in einen flachen Kunststoff-Trägerkörper bestimmt ist, zum Beispiel in eine Chipkarte im Kreditkartenformat, Fortsätze **26** und **27** bzw. Randbereiche des Systemträgers **20** rings um das Gehäuse **10** entlang den Biegelinien **30** abgekröpft, wie aus den **Fig. 5** und **6** hervorgeht. Diese Abkröpfungen nach oben und aussen erfolgen in Richtung zu der dem Systemträger **20** gegenüberliegenden Aussenfläche **11** des Elektronikmoduls hin; im vorliegenden Beispiel erstrecken sie sich über die ganze Dicke des Elektronikmoduls, derart, dass die Enden der genannten Fortsätze **26** und **27** in die Ebene der den Aussenkontakten **21** gegenüberliegenden Flachseite **11** des Kunststoffgehäuses **10** zu liegen kommen. Die beiden Fortsätze **27**, welche bezüglich des Gehäuses **10** einander gegenüberliegen, sowie ein Teil der Fortsätze **26** sind jeweils mit den Aussenkontakten **21** mechanisch verbunden, während weitere Fortsätze **26** von den beiden mit der Chipinsel **22** verbundenen Brücken **25** ausgehen, dies gemäss **Fig. 1**. Die weiter oben im Zusammenhang mit **Fig. 1** erwähnten fensterartigen Durchbrüche **29** befinden sich nun gemäss **Fig. 5** und **6** im Bereich der Abkröpfungen.

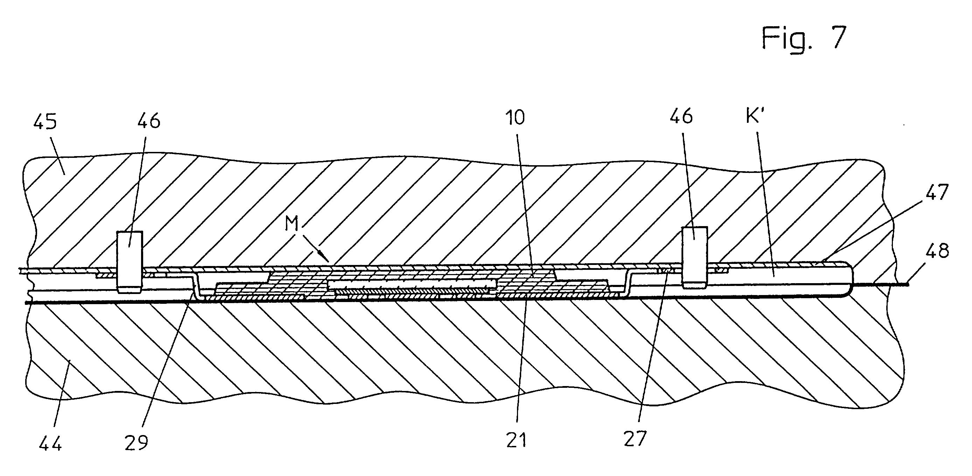

Das hiermit fertiggestellte Elektronikmodul nach **Fig. 5** und **6** ist nun bereit, um in eine weitere Spritzgiessform nach **Fig. 7** mit den Formhälften **44** und **45** eingelegt zu werden, in welcher es in die Chipkarte eingegossen wird. In den Enden der beiden Fortsätze **27** sind zweckmässigerweise Öffnungen **35** vorgesehen, für den Angriff von Greifern eines Montageroboters. Daneben befinden sich Zentrieröffnungen **36**, in die Zentrierstifte **46** der Giessform nach **Fig. 7** eingreifen, um das Elektronikmodul im Formhohlraum **K'** für die Chipkarte genau zu positionieren. Es ist hervorzuheben, dass diese Positionierung direkt an den Aussenkontakten **22** des Elektronikmoduls erfolgt und nicht mittelbar über das Kunststoffgehäuse **10** des Elektronikmoduls; dadurch erreicht man eine präzise Positionierung der Aussenkontakte **22** innerhalb der Chipkarte.

Die ausserhalb des Kunststoffgehäuses **10** liegenden Fortsätze **27** des Systemträgers **20** sind allgemein zum Zusammenwirken mit Montageautomaten beim Handling des in **Fig. 7** mit **M** bezeichneten Elektronikmoduls bestimmt. Die Greifer- und/oder Positionierungskonturen **35, 36**, die auch anders als dargestellt ausgebildet sein können, stehen wie schon erwähnt zu den Aussenkontakten **21** des Elektronikmoduls **M** in genauer Lagebeziehung. Damit wird ein sicheres automatisches Manipulieren und ein genaues Positionieren, beispielsweise auch bei Testoperationen und beim Verpacken, gewährleistet. Eine hohe Positionierungsgenauigkeit erhält man einerseits durch den Angriff am Systemträger **20** statt am Kunststoffgehäuse, und zwar sowohl materialbedingt wie auch durch den direkten Angriff am die Aussenkontakte bildenden Systemträger, und anderseits durch den relativ grossen Abstand zwischen den Konturen **36, 37** an den beiden Fortsätzen **27**.

In die Giessform **44,45** kann gemäss **Fig. 7** eine dünne Dekorationsfolie **48** eingelegt werden., auf die das Elektronikmodul **M** mit seiner Flachseite **12** einschliesslich seiner Aussenkontakte **22** zu liegen kommt. Bei dieser Dekorationsfolie **48** handelt es sich beispielsweise um eine bedruckte Folie für ein Thermotransfer-Druckverfahren, bei dem sich das auf der Folie vorhandene Druckmuster nur mit dem in den Formhohlraum **K'** einzustritzenden Kunststoff verbindet, nicht aber mit den metallischen Teilen des Elektronikmoduls **M**. Mit der Dekorationsfolie **48** wird auf an sich bekannte Weise die betreffende Seite der Chipkarte bedruckt.

Das Elektronikmodul **M** ist in der oberen Formhälfte **45** von einer Etikette **47** überdeckt, die sich über die ganze Chipkarte erstreckt und die ihrerseits bedruckt ist.

Das Einspritzen des die Chipkarte bildenden Kunststoffes, eines Thermoplasts, vorzugsweise ABS, in den Formhohlraum **K'** erfolgt nach bekannter Technik. Dabei wird das Elektronikmodul **M** rings umgossen, wobei es mit dem die Chipkarte bildenden Kunststoff flächenbündig bzw. in fluchtender Konfiguration angeordnet ist. Der thermoplastische Kunststoff tritt dabei durch die fensterartigen Durchbrüche **29** wie auch seitlich zwischen sämtlichen Fortsätzen **26, 27** hindurch. Dabei entsteht eine äusserst stabile mechanische Verankerung der über das Kunststoffgehäuse des Elektronikmoduls **M** hinausragenden Randbereiche des Systemträgers **20** im Kunststoff der Chipkarte. Von Bedeutung ist auch, dass das Elektronikmodul **M** an keiner der Flachseiten **11, 12** seines Kunststoffgehäuses **10** mit dem thermoplastischen Kunststoff der Chipkarte hintergossen wird. Die Dicke der Chipkarte ist also gleich der Dicke des Elektronikmoduls **M**. Für das Kunststoffgehäuse **10** des Elektronikmoduls **M** steht also die gesamte mögliche Dicke zur Verfügung. Bei der genormten Kartendicke von maximal 0,84 mm und einer Dicke der Etikette **47** von beispielsweise 0,12 mm bleibt somit für das Kunststoffgehäuse **10** des Elektronikmoduls **M** eine Dicke von 0,72 mm.

Das beschriebene Elektronikmodul bzw. geeignete Varianten desselben empfiehlt sich auch zum Eingiessen in andere flache Chipkarten bzw. Trägerkörper wie z.B. elektronische Schlüssel. Grundsätzlich sind jedoch auch andere Einbau- und Verwendungsarten möglich, wo die Flachbauweise des Elektronikmoduls verlangt ist oder besondere Vorteile bringt, wie etwa bei Komponenten für Oberflächenmontage (SMD-Technik, surface mounted devices).

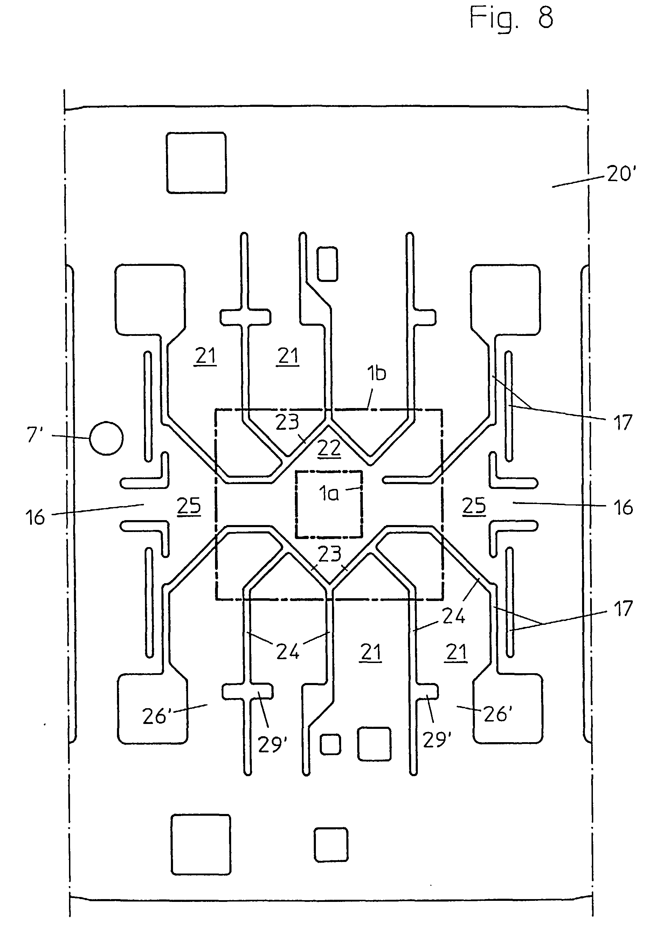

Eine weitere Ausführungsform des Elektronikmoduls in Flachbauweise und der Herstellung desselben geht aus den **Fig. 8** bis **13** hervor; das Spritzgiessen des Kunststoffgehäuses des Elektronikmoduls und das Eingiessen des Elektronikmoduls in eine Chipkarte oder einen anderen Tragkörper sind indessen nicht separat dargestellt und es wird auf die betreffenden **Fig. 4** und **7** und die zugehörige Beschreibung verwiesen. Manche Bauteile des Elektronikmoduls gemäss der Variante nach **Fig. 8** bis **13** entsprechen denjenigen der vorstehend beschriebenen Ausführungsform und sind mit gleichen Bezugszeichen versehen.

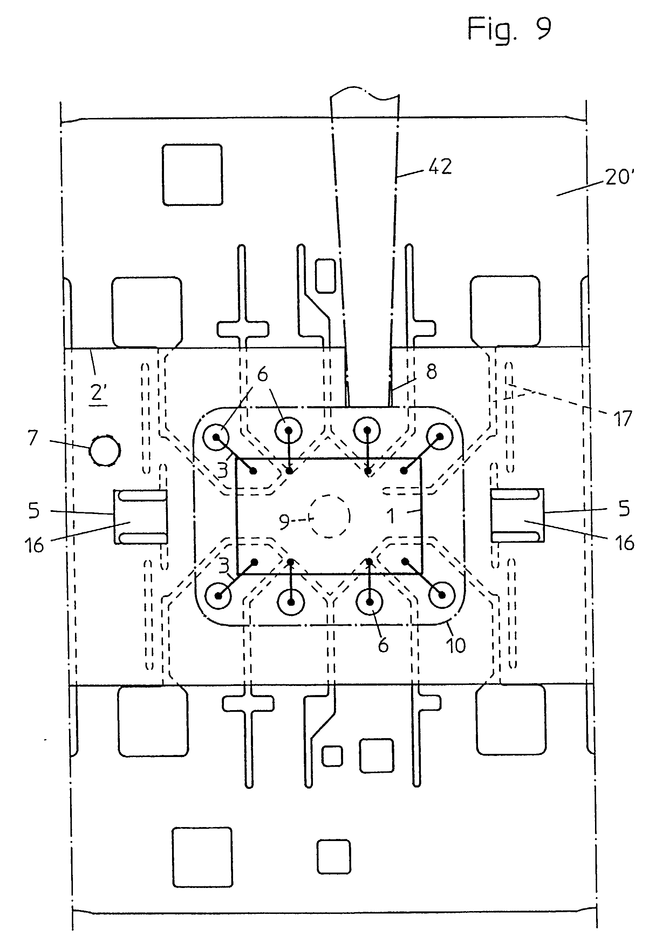

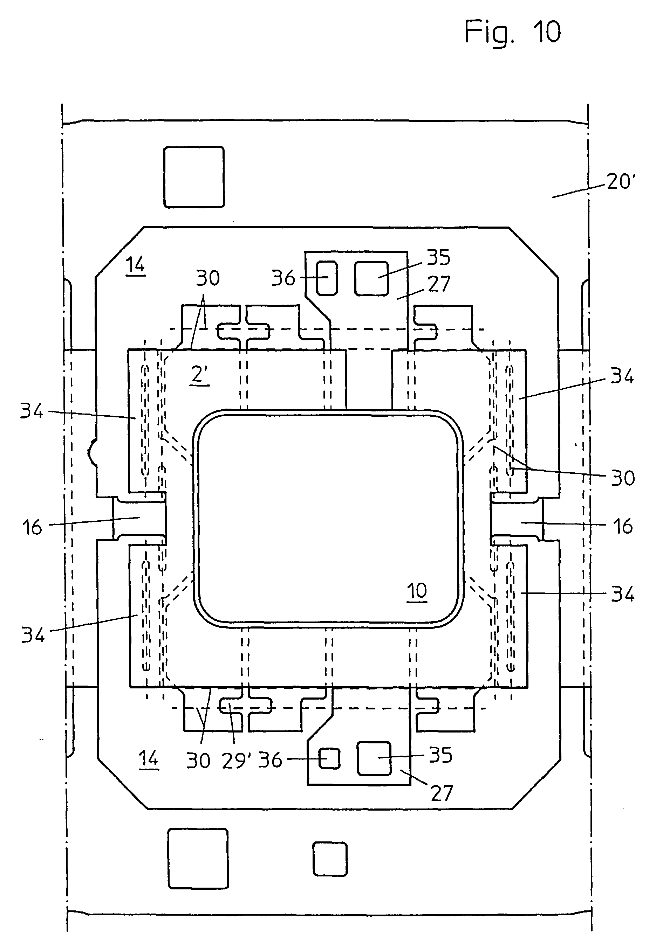

Am Systemträger **20'** nach **Fig. 8** sind dagegen folgende Abweichungen gegenüber dem Systemträger **20** zu erwähnen: an den Aussenkontakten **21** sind die von der Chipinsel **22** entfernten Partien untereinander nicht über Stege entsprechend den Stegen **28** der **Fig. 1** verbunden, sondern sie gehen getrennt in die seitlichen Randbereiche des Systemträgers **20'** über. Die Aussenkontakte **21** weisen keine Durchbrüche entsprechend den Durchbrüchen **31** und **29** der **Fig. 1** auf. Es sind dagegen seitliche Einschnitte **29'** vorgesehen, auf welche Biegelinien **30** zu liegen kommen, wie dies aus **Fig. 10** hervorgeht. An den die Chipinsel **22** haltenden Brücken **25** sind die aussenliegenden Partien über Stege **16** mit dem Systemträger **20'** verbunden, und zu beiden Seiten der Stege **16** sind schlitzartige Durchbrüche **17** vorgesehen, die zueinander und zu den Aussenkontakten **21** parallel laufen und auf die weitere Biegelinien **30**, die aus **Fig. 10** ersichtlich ist, zu liegen kommen. In **Fig. 9** ist der auf dem Systemträger **20'** montierte und über die Leitungen **3** mit den Aussenkontakten **21** elektrisch verbundene Halbleiterchip **1** dargestellt. Der Halbleiterchip **1** ist mit dem Systemträger **20'** wiederum über die zwischen Halbleiterchip **1** und Systemträger **20'** liegende, isolierende Folie **2'** verbunden, jedoch ist bei der vorliegenden Ausführung die Folie **2'** weit über das Format des Halbleiterchips **1** ausgedehnt, indem sie sich auch über die Aussenkontakte **21** und die Brücken **25** sowie die Schlitze **17** erstreckt; insbesondere überdeckt die Folie **2'** auch alle Schlitze **23** und **24**, welche die Chipinsel **22** und die Aussenkontakte **21** begrenzen. Die Folie **2'** ist z. B. aus bandförmigem Material hergestellt, typischerweise aus Polyimid, zum Beispiel "KAPTON" oder "MYLAR", von ca. 50 µm Dicke.

Die Folie **2'** ist perforiert und weist folgende ausgestanzte Öffnungen auf, die vor dem Aufbringen auf dem Systemträger **20'** hergestellt werden: erstens zwei Öffnungen **5**, welche die Stege **16** frei lassen, zweitens Öffnungen **6** für die Durchführung der Drähte **3** auf die Aussenkontakte **21**, drittens eine zu Zentrierzwecken angeordnete Öffnung bzw. Bohrung **7**, die mit einer entsprechenden Bohrung **7'**, ersichtlich in **Fig. 8**, zur Deckung gebracht wird, viertens eine Öffnung in Form eines Randausschnittes **8** im Bereich eines Angusses **42**, der beim Spritzgiessen des Kunststoffgehäuses **10** des Elektronikmoduls M entsteht, wobei der Anguss **42** und das Kunststoffgehäuse **10** in **Fig. 9** strichpunktiert dargestellt sind, und sechstens bei Bedarf eine Öffnung **9** im Bereich der Chipinsel **22**, um die Unterseite des Halbleiterchips **1** mittels eines leitenden Klebers mit dem Systemträger **20** zu verbinden.

Der vorbereitete Abschnitt der Folie **2'** kann auf den Systemträger **20'** auflaminiert werden, wie weiter oben für die klebende Folie **2** im Zusammenhang mit **Fig. 2** beschrieben. Die Montage des Halbleiterchips **1** auf der Folie **2'** und die Kontaktierung mittels den Drahtverbindungen **3** erfolgen anschliessend ebenfalls wie mit Bezug auf die Ausführungsform der **Fig. 1** bis **7** beschrieben.

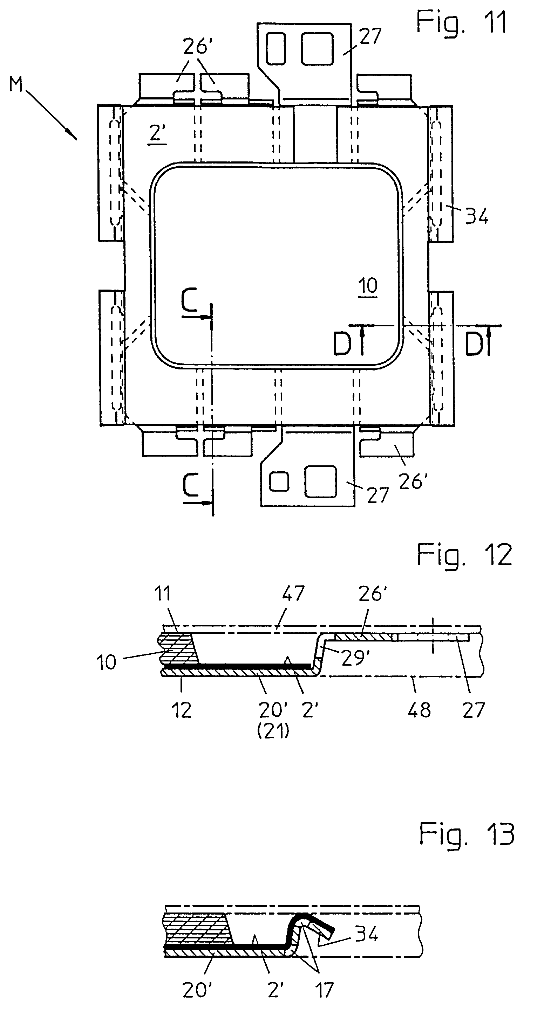

Die Folie **2'** erfüllt hier die Aufgabe, eine 'elastische' mechanische Verbindung zwischen Halbleiterchip **1** und Systemträger **20** herzustellen, sowie weitere Aufgaben: Durch die Klebefolie wird eine grossflächige, innige Verbindung zwischen den Kontakten **21**, der Chipinsel **22** und den Brücken **25** hergestellt. Beim Spritzgiessen des Kunststoffgehäuses **10** in einer Form analog der Form **40, 41** der **Fig. 4** verhindert die Folie **2'** das Eindringen von Kunststoff in die Schlitze **23, 24** und unter die Aussenkontakte **21** auf der unteren Aussenfläche des Elektronikmoduls **M**, d.h. das Entstehen von störendem "Flash" an dieser Aussenseite wird verhindert. Das an sich isolierende bzw. hochohmige Material, aus welchem die Folie **2'** hergestellt ist, und/oder die Klebstoffschicht kann auch eine gewisse gezielte, geringe elektrische Leitfähigkeit aufweisen, wodurch Spannungsspitzen, z.B. infolge elektrostatischer Entladungen, die auf die Aussenkontakte gelangen, wirksam gedämpft werden, so dass man einen sogenannten 'ESD-Schutz' erhält; bei Chipkarten ist dies besonders wichtig, weil dort die Aussenkontakte **22** freiliegen und voneinander isoliert sind. Eine zusätzliche, wichtige Funktion der Folie **2'** im Bereich der Schlitze **17** wird weiter unten anhand der **Fig. 11** und **13** erläutert.

Beim vorliegenden, zweiten Ausführungsbeispiel des Elektronikmoduls erfolgt die mechanische Verbindung des Kunststoffgehäuses **10** mit dem Systemträger **20'** praktisch ausschliesslich mittelbar über die Folie **2'**. Es hat sich erwiesen, dass die Haftung des Kunststoffes des Kunststoffgehäuses **10** auf der Folie **2'** einerseits und die Haftung der Folie **2'** auf dem Systemträger **20** anderseits erheblich stärker ist als die direkte Haftung zwischen dem Kunststoff des Kunststoffgehäuses **10** und dem Metall des Systemträgers **20**. Die Folie **2'** macht also das Elektronikmodul **M** erheblich robuster, vor allem verhindert sie wirksam ein Ablösen oder Ausreissen der Aussenkontakte **21** aus der Oberfläche der Chipkarte. Umgekehrt lässt sich nach dem Spritzgiessen des Kunststoffgehäuses des Elektronikmoduls **10** der Anguss **42**, der sich direkt auf dem Blech des Systemträgers **20** befindet, von letzterem leicht ablösen und am Rand des Kunststoffgehäuses **10** abbrechen.

Nachdem das Elektronikmodul aus der Spritzgiessform für sein Kunststoffgehäuse **10** entnommen und der Anguss **42** entfernt worden ist, werden gemäss **Fig. 10** zwei symmetrische Flächen **14** aus dem Systemträger **20'** ausgestanzt, wobei das Elektronikmodul jedoch noch an den beiden Stegen **16** gehalten bleibt. Bei diesem Freistanzen werden die Aussenkontakte **21** aussen abgetrennt, wobei sie jedoch durch die klebende Folie **2'** mit dem Kunststoffgehäuse **10** verbunden sind. Mit demselben Stanzvorgang werden die Konturen der Fortsätze **27** gebildet Gleichzeitig kann im oberen Fortsatz **27**, wo sich der Anguss **42** befand, die Öffnung **35** gestanzt werden. Zu beiden Seiten der beiden Stege **16**, im Bereich der schlitzartigen Durchbrüche **17**, sind auch vier Lappen **34** freigestanzt worden.

Als nächster Schritt werden nun die am Rand des Elektronikmoduls liegenden Randbereiche des metallischen Systemträgers **20** längs der Biegelinien **30** in einem Biegewerkzeug gekröpft; die Stege **16** bleiben dabei jedoch flach und halten das Elektronikmodul noch im Verband des bzw. der Systemträgers **20'**. Schliesslich werden in einem weiteren Stanzwerkzeug auch die Stege **16** weggeschnitten und damit die fertigen Elektronikmodule **M** aus dem Systemträger **20'** gelöst, wie dies aus **Fig. 11** ersichtlich ist.

Die in der beschriebenen Weise vollautomatisch produzierten Elektronikmodule **M** nach den **Fig. 11** bis **13** können nun, analog wie beim vorangehenden Beispiel mit Bezug auf **Fig. 7** beschrieben, im Spritzgiessverfahren in eine Chipkarte oder einen anderen Träger eingegossen werden. Dabei ergeben sich im wesentlichen dieselben Eigenschaften und Vorteile hinsichtlich zuverlässiger Verankerung usw. Das Umgiessen und Verbinden mit dem das Elektronikmodul umgebenden Kunststoff des Trägers erfolgt wiederum an der das Kunststoffgehäuse **10** umgebenden ebenen Fläche, von der Folie **2'** bedeckt, und an den abgekröpften Teilen **26', 27** und **34**, wie dies aus den **Fig. 11** bis **13** leicht zu erkennen ist.

Aus der **Fig. 13** ist schliesslich die weiter oben angedeutete zusätzliche Funktion der über die schlitzartigen Durchbrüche **17** gezogenen Folie **2'** ersichtlich: Beim Spritzgiessen des Trägers bzw. der Chipkarte dringt der Kunststoff in die Durchbrüche **17** ein, bleibt dort aber durch die Folie **2'** getrennt. Dies ergibt eine vorteilhafte Scharnierwirkung entlang der Schlitze **17**, d.h. Biegungen des Trägers bzw. der Chipkarte werden dort weitgehend aufgenommen und entsprechend vom Elektronikmodul **M** bzw. vom Halbleiterchip **1** ferngehalten. Bei Bedarf wäre es selbstverständlich möglich, auch im Bereich der Fortsätze **26'** und **27** an den Aussenkontakten **21** dieselbe Massnahme vorzusehen, d.h. auch dort schlitzartige Durchbrüche vorzusehen und die Folie **2'** bis über die Fortsätze bzw. den Bereich der Abkröpfungen auszudehnen. Bei Chipkarten ist es allerdings so, dass - infolge der bekannten, genormten Anordnung des Elektronikmoduls M innerhalb der rechteckigen Chipkarte - die Verbindung der Lappen **34** mit dem Kunststoff der Chipkarte erheblich grösseren Biegebeanspruchungen ausgesetzt ist als die entsprechende Verbindung bei den Fortsätzen **26', 27**.

## Patentansprüche

1. Elektronikmodul **(M)** in Flachbauweise, umfassend
- einen Systemträger **(20, 20')**, der aus einem Abschnitt eines Metallstreifens mit vorgestanzten Durchbrüchen gebildet und innerhalb von Randbereichen eben ist,
- von denen einige Durchbrüche **(23, 24)** schlitzartig und in ihrer Längsrichtung beidseitig geradlinig berandet sind und Aussenkontakte **(21)** sowie eine mindestens annähernd rechteckige, zur Aufnahme eines Halbleiterchips **(1)** bestimmte Chipinsel **(22)** begrenzen, und
- von denen andere Durchbrüche **(35, 36)** in Randbereichen des Systemträgers **(20, 20')** angeordnet sind,
- den über der Chipinsel **(20, 20')** montierten rechteckigen Halbleiterchip **(1)**, dessen Kanten gegenüber den Rändern der Chipinsel **(20, 20')** um einen Winkel gedreht sind, damit die durch die Durchbrüche **(23, 24)** verursachten Schwächungslinien des Systemträgers **(20, 20')** nicht mit den parallel zu den Kanten des Halbleiterchips **(1)** gerichteten potentiellen Bruchstellen des Halbleiterchips **(1)** zusammenfallen,
- Drahtverbindungen **(3)** zwischen dem Halbleiterchip **(1)** und den Aussenkontakten **(21)**, und
- eine Kunststoffmasse, welche ein Kunststoffgehäuse **(10)** bildet und mit Ausnahme der Randbereiche des Systemträgers **(20, 20')** diesen überdeckt und den Halbleiterchip **(1)** und die Drahtverbindungen **(3)** umgibt, wobei die Aussenkontakte **(21)** an einer Flachseite des Kunststoffgehäuses **(10)** freiliegen.

2. Elektronikmodul (**M**) nach Patentanspruch **1**,
**dadurch gekennzeichnet**,
dass auf dem Systemträger (**20**, **20'**) eine Folie (**2, 2'**) angebracht ist, wobei der Halbleiterchip (**1**) auf der Folie, (**2**, **2'**) oder in einer Aussparung der Folie (**2, 2'**) montiert ist.

3. Elektronikmodul (**M**) nach mindestens einem der obigen Patentansprüche,
**dadurch gekennzeichnet**,
dass sich der Halbleiterchip (**1a**) vollständig über der Chipinsel (**22**) befindet.

4. Elektronikmodul (**M**) nach mindestens einem der obigen Patentansprüche,
**dadurch gekennzeichnet**,
dass der Halbleiterchip (**1b**) über die Chipinsel (**22**) hinausragt und sich mit mindestens einem Teil der Aussenkontakte (**21**) überlappt.

5. Elektronikmodul (**M**) nach mindestens einem der obigen Patentansprüche,
**dadurch gekennzeichnet**,
dass die Folie (**2, 2'**) sich höchstens bis zu den die Chipinsel (**22**) begrenzenden Durchbrüchen (**23**) erstreckt.

6. Elektronikmodul (**M**) nach mindestens einem der obigen Patentansprüche,
**dadurch gekennzeichnet**,
dass sich die Folie (**2**, **2'**) höchstens innerhalb der Randbereiche erstreckt.

7. Verfahren zur Herstellung eines Elektronikmoduls **(M)** nach mindestens einem der obigen Patentansprüche, wobei
- ein als Systemträger **(20, 20')** dienender Abschnitt von einem ebenen Metallstreifen abgetrennt wird, welcher Systemträger **(20)** der Fläche des Elektronikmoduls **(M)** einschliesslich von Randbereichen entspricht, wobei im Metallstreifen Durchbrüche sind,
- von welchen einige Durchbrüche **(23, 24)** schlitzförmig sind und Aussenkontakte **(21)** sowie eine mindestens annähernde rechteckige, zur Aufnahme eines Halbleiterchips **(1)** bestimmte Chipinsel **(22)** begrenzen, wobei die schlitzförmigen Durchbrüche **(23, 24)** längs der Aussenkontakte b bzw. der Chipinsel **(22)** in ihrer Längsrichtung beidseitig durch Geraden berandet sind, und
- von welchen andere Durchbrüche in den Randbereichen des Systemträgers **(20. 20')** angeordnet sind,
- über der Chipinsel **(22)** der viereckige Halbleiterchip **(1)** montiert wird, wobei seine Kanten gegenüber den die Chipinsel **(22)** begrenzenden Durchbrüchen **(23)** um einen vorgestimmten Winkel gedreht sind, damit die durch die Durchbrüche **(23, 24)** verursachten Schwächungslinien des Systemträgers **(20, 20')** nicht mit den parallel zu den Kanten des Halbleiterchips **(1)** gerichteten potentiellen Bruchstellen des Halbleiterchips **(1)** zusammenfallen,
- je eine Drahtverbindung **(3)** zwischen dem Halbleiterchip **(1)** und jedem der Aussenkontakte **(21)** hergestellt werden,
- der Systemträger **(20, 20')** mit dem Halbleiterchip **(1)** und den Drahtverbindungen **(3)** in eine einen Formhohlraum **(10')** bildende Giessform **(40, 41)** eingebracht wird, in welcher er aufliegt, wobei die Randbereiche des Systemträgers **(20, 20')** aus dem Formhohlraum **(10')** ragen,
- Kunststoff in den Formhohlraum **(10')** der Giessform **(40, 41)** eingebracht wird, um den Systemträger **(20, 20')** zu bedecken, den Halbleiterchip **(1)** mit den Drahtverbindungen **(3)** von oben und von den Seiten zu umpressen, zwecks Bildung eines Kunststoffgehäuses **(10)**, an dessen unterer Flachseite **(12)** die Aussenkontakte **(21)** freiliegen, und
- der Systemträger **(20, 20')** ausserhalb der Randbereiche durchtrennt und die Randbereiche des Systemträgers **(20, 20')** an mindestens zwei sich gegenüberliegenden Seiten des Kunststoffgehäuses **(20, 20')** nach oben über die Höhe des Kunststoffgehäuses **(10)** und aussen abgekröpft werden.

8. Verfahren nach Patentanspruch **7**,
**dadurch gekennzeichnet,**
dass auf dem Systemträger **(20, 20')** eine mindestens einseitig klebende Folie **(2, 2')** angebracht wird, und dass der Halbleiterchip **(1)** auf der als mechanisches Dämpfungsglied wirkenden und einen Unterschied der Wärmedilatation von Halbleiterchip **(1)** und Systemträger **(20, 20')** ausgleichenden Folie **(2, 2')** oder in einer Aussparung der Folie **(2, 2')** montiert wird.

9. Verwendung des Elektronikmoduls **(M)** nach mindestens einem der Patentansprüche **1** bis **6** zur Herstellung einer Chipkarte,
dadurch gekennzeichnet,
- dass das Elektronikmodul **(M)** in eine einen Formhohlraum **(K')** bildende Giessform **(44, 45)** eingebracht wird, dessen Höhe im wesentlichen der Höhe des Kunststoffgehäuses **(10)** des Elektronikmoduls **(M)** entspricht, und
- dass der Formhohlraum **(K')** mit Kunststoff ausgegossen wird, wonach das Elektronikmodul **(M)** seitlich von Kunststoff umgeben ist, während die Flachseiten **(11, 12)** seines Kunststoffgehäuses **(10)** in einer Ebene mit den beiden Aussenflächen der Chipkarte liegen,
- wobei die Positionierung des Elektronikmoduls **(M)** durch Positionierung der Durchbrüche **(35, 36)** seiner Randbereiche erfolgt.

10. Verwendung des Elektronikmoduls nach Patentanspruch **9**,
**dadurch gekennzeichnet,**
dass vor dem Einbringen des Kunststoffes in mindestens eine der Hälften der Giessform **(44, 45)** eine Dekorationsfolie **(48)** oder Etikette **(47)** eingelegt wird.

11. Chipkarte mit einem Elektronikmodul **(M)** nach mindestens einem der Patentansprüche **1** bis **6**,
**dadurch gekennzeichnet,**
dass sie als rechteckige Kreditkarte oder als elektronischer Schlüssel, vorzugsweise mit einer schlüsselähnlichen Kontur, ausgebildet ist.

## Claims

1. Electronic module (M) of thin construction, comprising
- a system carrier (20, 20') formed of a section of a metal-strip with pre-punched openings and flat within border areas,
- wherein some openings have the form of slits (23, 24) and are bordered along their longitudinal direction on both sides by straight lines and limit external contacts (21) as well as an at least approximately rectangular chip pad (22) determined for the reception of a semiconductor chip (1), and
- wherein some other openings (35, 36) are located at border areas of the system carrier (20, 20'),
- the rectangular semiconductor chip (1) mounted on the chip pad (22), the edges of which are rotated by an angle against the edges of the chip pad (22) in order that the lines of weakness of the system carrier (20, 20') caused by the openings (23, 24) do not coincide with the potential lines of fracture of the semiconductor chip (1) which are directed parallel to the edges of the semiconductor chip (1),
- wire connections (3) between the semiconductor chip (1) and the external contacts (21), and
- plastic material which forms a plastic casing (10) and, with the exception of the border areas of the system carrier (20, 20'), covers the system carrier and surrounds the semiconductor chip (1) and the wire connections (3), whereby the external contacts (21) lie free on a flat side of the plastic casing (10).

2. Electronic module (M) according to claim 1, characterized in that a foil (2, 2') is applied on the system carrier (20, 20'), the semiconductor chip (1) being mounted on the foil (2, 2') or in an indentation of the foil (2, 2').

3. Electronic module (M) according to at least one of the preceding claims, characterized in that the semiconductor chip (1) is located completely on the chip pad (22).

4. Electronic module (M) according to at least one of the preceding claims, characterized in that the semiconductor chip (1) extends over the chip pad (22) and overlaps with at least a part of the external contacts (21).

5. Electronic module (M) according to at least one of the preceding claims, characterized in that the foil (2, 2') extends at most to the openings (23) limiting the chip pad (22).

6. Electronic module (M) according to at least one of the preceding claims, characterized in that the foil (2, 2') extends at most within the border areas.

7. Method for the manufacture of an electronic module (M) according to at least one of the preceding claims, wherein
- a section serving as a system carrier (20, 20') is separated from a flat metal-strip, which system carrier (20, 20') corresponds to the area of the electronic module (M) inclusively of border areas, the metal-strip having openings,
- of which some openings have the form of slits (23, 24) and limit external contacts (21) as well as an at least approximately rectangular chip pad (22) determined for the reception of a semiconductor chip (1), wherein the slit like openings (23, 24) are bordered along the external contacts (21) or the chip pad (22), respectively, on both sides along their longitudinal direction by straight lines, and of which other openings are arranged at the border areas of the system carrier (20, 20'),
- the rectangular semiconductor chip (1) is mounted on the chip pad (22) with its edges rotated by a predetermined angle against the openings (23) limiting the chip pad (22) in order that the lines of weakness of the system carrier (20, 20') caused by the openings (23, 24) do not coincide with the potential lines of fracture of the semiconductor chip (1) which are directed parallel to the edges of the semiconductor chip (1),
- a wire connection (3) is made between the semiconductor chip (1) and each of the external contacts (21),
- the system carrier (20, 20') with the semiconductor chip (1) and the wire connections (3) is placed in a mold (40, 41) forming a cavity (10') where it lies upon, whereby the border areas of the system carrier (20, 20') extend out of the cavity (10'),
- plastic material is injected into the cavity (10') of the mold (40, 41) in order to cover the system carrier (20, 20'), to apply pressure from top and from the sides to the semiconductor chip (1) with the wire connections (3) in order to form a plastic casing (10), having the external contacts (21) lying free on its flat bottom side (12), and
- to cut out the system carrier (20, 20') outside the border areas and to crank the border areas of the system carrier (20, 20') at at least two opposing sides of the plastic casing (20, 20') towards the top over the height of the plastic casing (10) and outwards.

8. Method according to claim 7, characterized in that an at least on one side sticking foil (2, 2') is applied on the system carrier (20, 20'), and in that the semiconductor chip (1) is mounted on the foil (2, 2') serving as a mechanical damping element and compensating a difference in thermal dilatation of the semiconductor chip (1) and the system carrier (20, 20') or in an indentation of the foil (2, 2').

9. Use of the electronic module (M) according to at least one of the claims 1 to 6 for the manufacture of a chip card, characterized in that
- the electronic element (M) is placed in a mold (44, 45) forming a cavity (K') the height of which correspondends essentially to the height of the plastic casing (10) of the electronic module (M), and in that
- plastic material is injected into the cavity (K') whereafter the electronic module (M) is surrounded at the sides with plastic material while the flat sides of its plastic casing (10) lie in a plane with the two surfaces of the chip card,
- whereby the positioning of the electronic module (M) is caused by positioning the openings (35, 36) of its border areas.

10. Use of the electronic module (M) according to claim 9, characterized in that a decoration foil (48) or a label (47) is inlayed into at least one of the halves of the mold (44, 45) before the injection of the plastic material.

11. Chipcard with an electronic module (M) according to at least one of the claims 1 to 6, characterized in that it is formed as rectangular credit card or as electronic key, preferrably with a key like contour.

## Revendications

1. Module électronique (M) en boîtier de plat, comprenant :
- un support (20, 20'), qui est construit à partir d'une découpe d'une feuille métallique ayant des ouvertures poinçonnées, et qui est plan à l'intérieur des zones de bord,
- dans lequel quelques ouvertures (23, 24) sont en forme de fente et sont bordées sur leur longueur des deux côtés par une ligne droite, et délimite des contacts externes (21) ainsi que un îlot pour la puce (22), destiné à accueillir une puce de semiconducteur (1), dont la forme s'approche au moins d'un rectangle, et
- dans lequel d'autres ouvertures (35, 36) sont arrangées dans les zones de bord du support (20, 20'),
- la puce de semiconducteur (1) rectangulaire, montée sur l'îlot pour la puce (20, 20'), dont les côtés sont tournés d'un certain angle par rapport aux bords de l'îlot pour la puce (20, 20'), les lignes de faiblesse provoquées par les ouvertures (23, 24) du support (20, 20') ne se trouvant pas ainsi parallèles aux lignes de fracture potentielle de la puce de semiconducteur (1), lesquelles sont dirigées selon les côtés de la puce de semiconducteur (1),
- des liaisons filaires (3) entre la puce de semiconducteur (1) et les contacts externes (21), et
- une masse de matière plastique, laquelle forme un boîtier en matière plastique (10) et qui recouvre celui-ci, à l'exception des zones de bord du support (20, 20') et entoure la puce de semiconducteur (1) et les liaisons filaires (3) les contacts externes (21) se trouvant ainsi libres sur un côté plat du boîtier en matière plastique (10).

2. Module électronique conforme à la revendication 1, caractérisé en ce que, sur le support (20, 20') une feuille (2, 2') est appliquée, la puce de semiconducteur (1) étant montée sur la feuille (2, 2') ou dans une épargne de la feuille (2, 2').

3. Module électronique (M) conforme à l'une au moins des revendications mentionnées ci-dessus, caractérisé en ce que la puce de semiconducteur (la) se trouve en entier sur l'îlot pour la puce (22).

4. Module électronique (M) conforme à l'une au moins des revendications mentionnées ci-dessus, caractérisé en ce que la puce de semiconducteur (1b) saille de l'îlot pour la puce (22) et recouvre au moins une partie des contacts externes (21).

5. Module électronique (M) conforme à l'une au moins des revendications mentionnées ci-dessus, caractérisé en ce que, la feuille (2, 2') s'étend au plus jusqu'aux ouvertures (23) délimitant l'îlot pour la puce (22).

6. Module électronique (M) conforme à l'une quelconque des revendications mentionnées ci-dessus, caractérisé en ce que la feuille (2, 2') s'étend au plus à l'intérieur des bords.

7. Procédé pour fabriquer un module électronique (M) conformément à l'une au moins des revendications mentionnées ci-dessus, dans lequel :
- une pièce servant de support (20, 20') est découpée dans une feuille métallique plane, lequel support (20) comprend les côtés du module électronique (M) y compris les zones de bord, des ouvertures se trouvant dans la plaque métallique,
- parmi lesquelles quelques ouvertures (23, 24) sont en forme de fente et délimitent des contacts externes (21) ainsi qu'un îlot pour la puce (22) dont la forme s'approche au moins d'un rectangle, destiné à accueillir une puce de semiconducteur (1), les ouvertures en forme de fente (23, 24) étant bordées, le long des contacts externes (21) respectivement de l'îlot pour la puce (22), par des droites des deux côtés selon leur longueur, et
- parmi lesquelles d'autres ouvertures (35, 36) sont arrangées dans les zones de bord du support (20, 20'),
- sur l'îlot pour la puce (20, 20'), la puce de semiconducteur (1) rectangulaire est montée, ses côtés étant tournés d'un certain angle par rapport aux ouvertures délimitant l'îlot pour la puce (20, 20'),
- des liaisons filaires respectives (3)sont établies entre la puce de semiconducteur (1) et chaque contact externe (21),
- le support (20, 20') muni de la puce de semiconducteur (1) et des liaisons filaires (3) est installé dans la cavité (10') formant un moule d'injection, dans lequel il repose, les bordures du support (20, 20') saillant de la cavité de moulage (10'),
- de la matière plastique est introduite dans la cavité (10') du moule d'injection (40, 41) de façon à recouvrir le support (20, 20'), pour enrober la puce de semiconducteur (1) munie des liaisons filaires (3) sur le dessus et sur les côtés, pour former un boîtier en matière plastique (10), sur le côté plat inférieur (12) duquel les contacts externes (21) sont libres, et
- le support (20, 20') passe au travers les zones de bord, et les zones de bord du support (20, 20') sont recourbées, en au moins deux côtés opposés du boîtier en matière plastique (20, 20'), vers le haut pardessus la hauteur du boîtier en matière plastique (10) et vers l'extérieur.

8. Procédé conforme à la revendication 7, caractérisé en ce que, sur le support (20, 20') une feuille (20, 20') adhésive au moins d'un côté est amenée, et la puce de semiconducteur (1) est montée sur la feuille (2, 2') ou dans une épargne de la feuille (2, 2') qui sert d'amortisseur mécanique et qui équilibre la différence de dilation thermique entre la puce de semiconducteur (1) et le support (20, 20').

9. Utilisation du module électronique (M) conformément à l'une au moins des revendications 1 à 6 pour fabriquer une carte à puce, caractérisée en ce que,
- le module électronique (M) est introduit dans une cavité de moulage (K') formant un moule d'injection (40, 45), dont la hauteur comprend sensiblement à la hauteur du boîtier en matière plastique (10) du module électronique (M), et
- la cavité (K') est remplie de matière plastique, le module électronique (M) étant alors entouré latéralement de matière plastique, tandis que les côtés plats (11, 12) de son boîtier en matière plastique (10) sont dans le plan des deux faces externes de la carte à puce,
- le positionnement du module électronique (M) se produisant grâce au positionnement des ouvertures (35, 36) de sa zone de bordure.

10. Utilisation du module électronique conforme à la revendication 8 caractérisée en ce que, avant l'injection de la matière plastique dans au moins une des moitiés du moule d'injection (44, 45), une feuille de décoration (48) ou une étiquette (47) est déposée.

11. Carte à puce avec un module électronique (M) conforme à l'une au moins des revendications 1 à 6, caractérisée en ce qu'elle a la forme d'une carte de crédit rectangulaire ou d'une clé électronique, de préférence avec un contour approchant la forme d'une clé.
